# EUROPEAN PATENT APPLICATION

(11) **EP 1 610 360 A1**
(43) Date of publication of application: **28.12.2005**
(21) Application number: 04724415.7
(22) Date of filing: 30.03.2004
(51) Int. Cl.: H01L 21/02, C23C 16/44, C23C 16/52, C04B 41/87

(54) **DUMMY WAFER**

(30) Priority: 31.03.2003 JP 2003096293
(71) Applicant: Nippon Oil Corporation, Tokyo 105-8412 (JP)
(72) Inventor: UCHIDA, Daisuke, c/o Nippon Oil Corporation, Tokyo 1058412 (JP); KOBAYASHI, Takashi, c/o Nippon Oil Corporation, Tokyo 1058412 (JP); AOYAGI, Kenichi, c/o Nippon Oil Corporation, Yokohama-shi, Kanagawa 2310815 (JP); TAKEMURA, Shinichi, c/o Nippon Oil Corporation, Yokohama-shi, Kanagawa 2310815 (JP)
(74) Representative: Loisel, Bertrand
(86) International application number: PCT/JP2004/004514
(87) International publication number: WO 2004/088733

(57) **Abstract**

A dummy wafer including a carbon fiber reinforced plastic (CFRP). Specifically the dummy wafer has a wafer substrate including CFRP, the substrate has two skin layers disposed on respective principal surface side and a core layer interposed between the skin layers, and each of the skin layers has multiple one-dimensionally reinforced layers consisting of a cured and shaped product of unidirectional prepreg. With reference to the orientation direction of one of the one-dimensionally reinforced layers on the side closest to the principal surface (outermost layer) in each of the skin layers, the other outermost layer is oriented in a specific direction; the tensile modulus of CF in each outermost layer is within a specific range; each skin layer has a one-dimensionally reinforced layer that contains CF oriented in a specific direction and has the tensile modulus within a specific range; and the core layer has a one-dimensionally reinforced layer that contains CF oriented in a specific direction and having the tensile modulus within a specific range, and a one-dimensionally reinforced layer that contains CF oriented in a specific direction and having the tensile modulus within a specific range. The dummy wafer has high strength, is inexpensive, and easily responds to light sensors.

## Description

### Technical Field

The present invention relates to a dummy wafer that is used in a process for manufacturing a semiconductor such as a semiconductor integrated circuit and a semiconductor memory.

### Background Art

Heretofore, in processes for manufacturing semiconductors, such as semiconductor integrated circuits and semiconductor memories, processing known as dummy processing, wherein various processing is performed using a dummy wafer on which no actual IC pattern is formed, has been performed for the operation test of, for example, a plasma etching apparatus, a CVD apparatus, a sputtering apparatus or the like; the number adjustment of wafers in batch process; the countermeasure against the loading effect; or the like. In addition, when cleaning of the reaction chamber of various plasma apparatuses, such as a plasma CVD apparatus is performed with plasma cleaning, a dummy wafer has also been used for protecting a substrate-supported electrode from the plasma.

Heretofore, the following dummy wafers have been used in the process for manufacturing semiconductor devices, and each of them has had a problem:
(a) Silicon dummy wafer: It is expensive and brittle, and cannot be reused. Since the number to be used is the same as the number of wafers, the costs for manufacturing semiconductors are significantly elevated.
(b) Quartz dummy wafer: It is hard to respond to a light sensor.
(c) Ceramic dummy wafer: It is heavy. There is the case when it is hard to respond to a light sensor.
(d) Glassy carbon dummy wafer: It has a problem to produce dust.

Although a technique to solve these problems has been disclosed in, for example, Japanese Patent Laid-Open No. 2002-175959, there is still room for improvement in aspects of mechanical strength and the like.

### Disclosure of the Invention

It is an object of the present invention to provide a dummy wafer that is rigid and has a high strength even when it is thin and of large diameter, e.g., 300 mm in diameter × 0.5 mm to 0.75 mm in thickness, is relatively inexpensive, and easily responds to a light sensor. It is another object of the present invention to provide a dummy wafer that produces little dust or a dummy wafer that resists to heat.

Further object of the present invention is to provide a dummy wafer that has substantially uniform flexural rigidity and is excellent in planarity, preferably even if it is very thin below the SEMI standard.

According to the present invention, the following dummy wafer is provided:
1) A dummy wafer comprising a carbon fiber reinforced plastic.
2) The dummy wafer as set forth in 1) having a wafer substrate including a carbon fiber reinforced plastic.
3) The dummy wafer as set forth in 2), wherein said carbon fiber reinforced plastic includes carbon fibers having a tensile modulus of 400 GPa or higher.
4) The dummy wafer as set forth in 3), wherein said carbon fibers are pitch-based carbon fibers.
5) The dummy wafer as set forth in 2), wherein said wafer substrate has a plurality of CFRP layers which are layers consisting of a carbon fiber reinforced plastic.
6) The dummy wafer as set forth in 5), wherein said wafer substrate has a plurality of one-dimensionally reinforced CFRP layers, said one-dimensionally reinforced CFRP layer being a layer consisting of a carbon fiber reinforced plastic consisting of a cured and shaped product of a unidirectional prepreg in which carbon fibers are oriented in one direction, and
   the tensile modulus of the carbon fibers in a part of layers among said plurality of one-dimensionally reinforced CFRP layers is higher than the tensile modulus of the carbon fiber in the other layers.
7) The dummy wafer as set forth in 6), wherein
   said wafer substrate has two skin layers each located on principal surface side, and a core layer located between said two skin layers;
   both of said two skin layers have a plurality of said one-dimensionally reinforced CFRP layers;
   when the orientation direction of carbon fibers in one of the two outermost CFRP layers, which are one-dimensionally reinforced CFRP layers located closest to the principal surface side in each of said two skin layers, is made to be a reference direction, the orientation direction of carbon fibers in the other outermost CFRP layer falls within an angle range from -20° to +20° with respect to the reference direction;
   the tensile modulus of carbon fibers in both the two outermost CFRP layers is 200 GPa to 600 GPa;
   both the two skin layers have a one-dimensionally reinforced CFRP layer containing carbon fibers oriented in an angle range from +75° to +90° with respect to the reference direction and having a tensile modulus of 400 GPa to 1000 GPa and higher than the tensile modulus of carbon fibers in either outermost CFRP layer and/or a one-dimensionally reinforced CFRP layer containing carbon fibers oriented in an angle range from -75° to -90° with respect to the reference direction and having a tensile modulus of 400 GPa to 1000 GPa and higher than the tensile modulus of carbon fibers in either outermost CFRP layer; and
   said core layer has a one-dimensionally reinforced CFRP layer containing carbon fibers oriented in an angle range from +30° to +60° with respect to the reference direction and having a tensile modulus of 400 GPa to 1000 GPa, and/or a one-dimensionally reinforced CFRP layer containing carbon fibers oriented in an angle range from -30° to -60° and having a tensile modulus of 400 GPa to 1000 GPa.
8) The dummy wafer as set forth in 7), wherein the thickness of each of said two skin layers is 10% to 45% the total thickness of said two skin layers and the core layer.
9) A dummy wafer comprising a wafer substrate including a carbon fiber reinforced plastic, wherein
   said wafer substrate has two skin layers each located on principal surface sides, and a core layer located between said two skin layers;
   both of said two skin layers have a plurality of one-dimensionally reinforced CFRP layers, said one-dimensionally reinforced CFRP layer being a layer consisting of a carbon fiber reinforced plastic consisting of a cured and shaped product of a unidirectional prepreg in which carbon fibers are oriented in one direction;
   when the orientation direction of carbon fibers in one of the two outermost CFRP layers, which are one-dimensionally reinforced CFRP layers located closest to the principal surface side in each of said two skin layers, is made to be a reference direction, the orientation direction of carbon fibers in the other outermost CFRP layer falls within an angle range from -20° to +20° with respect to the reference direction;
   the tensile modulus of carbon fibers in both the two outermost CFRP layers is 200 GPa to 600 GPa;
   both the two skin layers have a one-dimensionally reinforced CFRP layer containing carbon fibers oriented in an angle range from +75° to +90° with respect to the reference direction and having a tensile modulus 1.5 times to 3.0 times that of carbon fibers of the outermost CFRP layer contained in the skin layer, and/or a one-dimensionally reinforced CFRP layer containing carbon fibers oriented in an angle range from -75° to -90° with respect to the reference direction and having a tensile modulus 1.5 times to 3.0 times that of carbon fibers of the outermost CFRP layer contained in the skin layer;
   said core layer has a one-dimensionally reinforced CFRP layer containing carbon fibers oriented in an angle range from -20° to +20° with respect to the reference direction and having a tensile modulus of 200 GPa to 400 GPa; and
   said core layer also has a one-dimensionally reinforced CFRP layer containing carbon fibers oriented in an angle range from +75° to +90° with respect to the reference direction and having a tensile modulus of 200 GPa to 400 GPa and/or a one-dimensionally reinforced CFRP layer containing carbon fibers oriented in an angle range from -75° to -90° with respect to the reference direction and having a tensile modulus of 200 GPa to 400 GPa.
10) The dummy wafer as set forth in 9), wherein at least one of said two skin layers further has a one-dimensionally reinforced CFRP layer containing carbon fibers oriented in an angle range from +30° to +60° with respect to the reference direction and having a tensile modulus 1.5 times to 3.0 times that of carbon fibers of the outermost CFRP layer contained in the skin layer, and/or a one-dimensionally reinforced CFRP layer containing carbon fibers oriented in an angle range from -30° to -60° with respect to the reference direction and having a tensile modulus 1.5 times to 3.0 times that of carbon fibers of the outermost CFRP layer contained in the skin layer.
11) The dummy wafer as set forth in any one of 6) to 10) further comprising a carbon fiber cloth layer on each of the principal surfaces.
12) The dummy wafer as set forth in any one of 1) to 11), wherein the matrix resin contained in said carbon fiber reinforced plastic contains an epoxy resin composition that contains diaminodiphenylsulfone as a curing agent.
13) The dummy wafer as set forth in any one of 2) to 12), wherein
   said wafer substrate has a processed surface, and
   has a coating layer that coats said processed surface and consists of a resin that has resistance against polar solvent and cures at a temperature of 70°C or lower.

In this description, unless otherwise specified, the expression of "X₁ to X₂" that indicates a range of numeric values means the range between X₁ and X₂ including both X₁ and X₂.

### Brief Description of the Drawings

Figure 1 is a schematic view illustrating an embodiment of a dummy wafer of the present invention, (a) being a top view and (b) being an A-A' sectional view;
Figures 2 (a) and (b) are schematic sectional views each illustrating other embodiments of dummy wafers of the present invention;
Figure 3 is a schematic sectional view illustrating an embodiment of a wafer substrate; and
Figure 4 is a schematic sectional view illustrating a dummy wafer manufactured in Example 1.

1: wafer substrate; 2a, 2b: principal surface, 3:end surface, 4: end surface coating layer, 5a, 5b:principal surface coating layer, 11a, b: skin layer, 12: core layer, 21a,b: CFRP layer containing PAN-based carbon fibers having a tensile modulus of 230 GPa, 22a, b: CFRP layer containing pitch-based carbon fibers having a tensile modulus of 800 GPa, 23a, b: glass-fiber reinforced plastic layer, 24: CFRP layers containing pitch-based carbon fibers having a tensile modulus of 600 GPa, 31a, b:carbon-fiber cloth layer.

### Best Mode for Carrying Out the Invention

### [Dummy wafer]

Although there is no particular limitation in the shape of the dummy wafer of the present invention, it is normally the same shape as the prime wafer used in an actual semiconductor product. The shapes of prime wafers are specified in, for example, the SEMI (Semiconductor Equipment and Materials International) Standard. The same applies to the dimensions of dummy wafers.

A carbon fiber reinforced plastic (hereafter referred to as CFRP) is light, difficult to break, can easily raise the plane flatness and reduce strain, easily responds to a light sensor, and is inexpensive compared with silicon and the like. Since the dummy wafer of the present invention contains such an excellent CFRP, it is extremely excellent in these aspects. In addition, since CFRP is not transparent like quartz and the like, it responds easily to a light sensor.

### [Matrix resin in CFRP]

CFRP can be obtained by impregnating a matrix resin into reinforcing fibers mainly composed of carbon fibers to form a prepreg, laminating the prepregs as required, and curing the matrix resin.

As the matrix resin, a thermosetting resin, a thermoplastic resin, and a mixture of two or more of these resins can be used; and in particular, a thermosetting resin can be preferably used.

As the thermosetting resin, thermosetting resins such as epoxy resins, aramid resins, bismaleimide resins, phenolic resins, furan resins, urea resins, unsaturated polyester resins, epoxy acrylate resins, diallyl phthalate resins, vinyl ester resins, thermosetting polyimide resins, and melamine resins can be used; and in particular, an epoxy resin can be preferably used.

As the thermoplastic resin, resins such as nylon resins, liquid crystalline aromatic polyamide resins, polyester resins, liquid crystalline aromatic polyester resins, polypropylene resins, polyether sulfone resins, polyphenylene sulfide resins, polyether ether ketone resins, polysulfone resins, polyvinyl chloride resins, vinylon resins, aramid resins, and fluorocarbon resins can be used.

### [Physical properties of matrix resin]

The matrix resin has a viscosity of preferably 5,000 poise to 1,000,000 poise, more preferably 10,000 poise to 1,000,000 poise, and further preferably 50,000 poise to 150,000 poise at 25°C; and preferably 1,000 poise to 30,000 poise, and more preferably 1,000 poise to 10,000 poise at 50°C. By making the viscosity at 25°C of the matrix resin for producing CFRP be not higher than 1,000,000 poise, the hardening of the prepreg and the lowering of tackiness can be excellently prevented; and by making the viscosity be not lower than 5,000 poise, the difficulty in correcting the lamination of the prepreg due to strong tackiness so that the once bonded prepreg when the prepreg is laminated is difficult to peel off can be excellently prevented. Furthermore, by making the viscosity at 50°C be not lower than 1,000 poise, the impregnation of the resin is easy and the increase in resin flow during shape forming can be excellently prevented; and by making the viscosity at 50°C be not higher than 30,000 poise, the decrease in resin flow during shape forming and the inferior impregnation of the resin can be excellently prevented.

### [Quantity of matrix resin in prepreg]

The quantity of the matrix resin contained in the prepreg is preferably selected to be within a range from 20% by mass to 50% by mass to the total quantity of the reinforcing fibers and the matrix resin, more preferably within a range from 25% by mass to 45% by mass, regardless of whether optional components, such as a filler, are contained or not.

### [Heat resistant epoxy resin composition]

If an epoxy resin composition using diaminodiphenyl sulfone as a curing agent is used as the matrix resin, the heat resistant temperature of a dummy wafer can be elevated to 230°C, a dummy wafer having extremely favorable composite properties and excellent heat resistance, and substantially free of out gas can be produced. Out gas is a gas that comes out of the resin, and it may be a contamination source of the semiconductor manufacturing process.

Although various epoxy resins can be used as the epoxy resin used in the above-described epoxy resin composition, an epoxy resin composition consisting of one or the combination of two or more selected from bisphenol-A epoxy resin, phenol novolak epoxy resin, glycidyl amine epoxy resin and bisphenol-F epoxy resin, and diaminodiphenyl sulfone is preferable.

As the bisphenol-A epoxy resin, a bisphenol-A epoxy resin that has a liquid form at 20°C is preferably used. Here, a liquid form at 20°C means that the viscosity of the resin is within a range of 1 poise to 1000 poise, preferably 10 poise to 500 poise at this temperature. Specific examples of bisphenol-A epoxy resins that have a liquid form at 20°C include bisphenol-A epoxy resins marketed under the trade names or product numbers of Epotohto YD128 and YD134 (manufactured by Tohto Kasei Co., Ltd.), and Epikote 828 and 834 (manufactured by Yuka Shell Epoxy Co., Ltd.). The content of the bisphenol-A epoxy resin in the epoxy resin composition is selected to be preferably within a range of 20 parts by mass to 40 parts by mass to 100 parts by mass of the total quantity of epoxy resins, more preferably 25 parts by mass to 35 parts by mass. By making the content of the bisphenol-A epoxy resin be 20 parts by mass or higher, it is possible to excellently prevent the difficulty of impregnation into the fiber bundle of carbon fibers or the like due to the increase in the viscosity of the epoxy resin composition, and to excellently prevent the lowering of tackiness when the prepreg, which is an intermediate material, is formed. On the other hand, by making the content be 40 parts by mass or lower, it is possible to excellently prevent the difficulty in handling of the prepreg when the prepreg is formed due to the elevation of tackiness, and it is possible to excellently prevent the lowering of the composite properties when a composite material is formed, and the lowering of heat resistance and moisture resistance.

As the phenol novolak epoxy resin, a phenol novolak epoxy resin that has a viscosity at 52°C of 10 poise to 3000 poise, and more preferably 10 poise to 2000 poise, is preferably used. Specific examples of usable resins include phenol novolak epoxy resins marketed under the trade names or product numbers of Epikote 152 and 154 (manufactured by Yuka Shell Epoxy Co., Ltd.), DEN 431, 438 and 439 (manufactured by Dow Chemical Co.), and Phenotohto YP 50 and YDPN 638 (manufactured by Tohto Kasei Co., Ltd.). The use thereof can improve the composite properties, heat resistance and moisture resistance of a composite material. The content of the phenol novolak epoxy resin in the epoxy resin composition is selected to be preferably within a range of 40 parts by mass to 60 parts by mass to 100 parts by mass of the total quantity of epoxy resins, more preferably 45 parts by mass to 55 parts by mass.

As the glycidyl amine epoxy resin, 4-functional glycidyl amine epoxy resin is preferable, and more specifically, tetraglycidyl diaminodiphenylmethane is preferable. This type of 4-functional glycidyl amine epoxy resin is marketed under the trade names or product numbers such as Epotohto YH 434 (manufactured by Tohto Kasei Co., Ltd.), ELM 434 (manufactured by Sumitomo Chemical Co., Ltd.), and Epikote 604 (manufactured by Yuka Shell Epoxy Co., Ltd.). By mixing this component in the epoxy resin composition, the composite properties, heat resistance and moisture resistance of CFRP can further be improved. The content thereof is selected to be preferably within a range of 10 parts by mass to 30 parts by mass to 100 parts by mass of the total quantity of epoxy resins, more preferably 15 parts by mass to 25 parts by mass.

The bisphenol-F epoxy resin is a condensation reaction product of bisphenol-F with epichlorohydrin. The bisphenol-F epoxy resin whose epoxy equivalent is within a range of 155 to 190, and whose viscosity at 25°C is within a range of 4.0 poise to 4.5 poise is preferably used. Examples of commercially available products include Epikote 807 (manufactured by Yuka Shell Epoxy Co., Ltd.), Epotohto YDF 170 (manufactured by Tohto Kasei Co., Ltd.), and Epiclon 830 (manufactured by Dainippon Ink & Chemicals, Inc.). When the bisphenol-F epoxy resin is blended to the epoxy resin composition, the blending quantity thereof is selected from ranges preferably 50 parts by mass or less, more preferably 40 parts by mass or less, and further preferably 15 parts by mass or less to 100 parts by mass of the total quantity of epoxy resins. By making the content be 50 parts by mass or less, the viscosity of the finally obtained epoxy resin composition can be easily controlled, the adequate prepreg can be easily prepared, and the lowering of the glass transition temperature of the cured product can be prevented to obtain excellent heat resistance.

As a further component, a phenoxy resin can be used, and typically, the phenoxy resin represented by the following formula or the epoxy-modified phenoxy resin thereof can be used. As specific examples of phenoxy resins, those marketed under the trade names or product numbers of YP 50 (manufactured by Tohto Kasei Co., Ltd.), and PKHH (manufactured by Phenoxy Associates) can be used. The content thereof can be selected to be preferably within a range of 5 parts by mass to 20 parts by mass to 100 parts by mass of the total quantity of epoxy resins, more preferably 7 parts by mass to 18 parts by mass.

As the diaminodiphenyl sulfone, 4,4'-diaminodiphenyl sulfone and 3,3'-diaminodiphenyl sulfone can be used, and 4,4'-diaminodiphenyl sulfone is preferable. This is a component that functions as a curing agent, and for example, Seikacure-S (trade name, manufactured by Wakayama Kasei Kogyo) can be preferably used. The Seikacure-S is in the form of powder having an average particle diameter of 8 µm to 9 µm. The quantity is selected from a range of preferably 30 parts by mass to 50 parts by mass to 100 parts by mass of the total quantity of epoxy resins in the epoxy resin composition, more preferably 35 parts by mass to 45 parts by mass. By making the quantity be 30 parts by mass or higher, the properties, heat resistance and moisture resistance when CFRP is formed are excellent; and by making the quantity be 50 parts by mass or lower, the epoxy resin composition can be easily impregnated into the fiber bundle.

It is preferable that diaminodiphenyl sulfone is in the form of fine particles that have diameters from 0.01 µm to 10 µm, and is dispersed in the above-described epoxy resin composition. For this dispersion, a publicly known dispersing method wherein appropriate means for kneading such as a kneader and a 3-roll machine is used can be adopted.

To the above-described epoxy resin composition, an epoxy resin other than that described above, a toughning agent, fillers, coloring agent, etc. can be blended as required within the range not to damage the properties. Fillers include inorganic fillers, such as mica, alumina, talc, fine silica powder, wollastonite, sepiolite, basic magnesium sulfate, zinc powder, aluminum powder, clay, calcium carbonate, titanium dioxide, calcium sulfate, barium sulfate, and carbon black; and organic fillers such as Teflon powder, polyethylene powder, polyamide powder, and EVA (ethylene-vinyl acetate copolymer) powder. When filler is added, the quantity of the added filer in the above-described epoxy resin composition can be normally about 5 parts by mass to 60 parts by mass to 100 parts of the total quantity of epoxy resins.

Coloring agents that can be used include azo pigments, phthalocyanine-based pigments, quinacridone-based pigments, anthraquinone-based pigments and the like as organic pigments; and titanium dioxide, chrome yellow, cobalt violet, colcothar as inorganic pigments.

In addition, in the above-described epoxy resin composition, a curing agent other than the above-described diaminodiphenyl sulfone or a curing accelerator can be blended as required. Examples of the curing agents include diaminodiphenyl sulfone, diaminodiethyl benzene or the like; and examples of curing accelerators include boron trifluoride monoethylamine complex, boron trichloride monoethylamine complex.

### [Carbon fibers in CFRP]

As carbon fibers contained in CFRP, pitch-based carbon fibers or polyacrylonitrile(PAN)-based carbon fibers can be used. From the point of view to obtain tensile modulus equivalent to or higher than the tensile modulus of a silicon wafer, the tensile modulus of the carbon fiber to be used is preferably 400 GPa or more, more preferably 500 GPa or more, and further preferably 600 GPa or more. In view of handling and shape-forming, the tensile modulus of the carbon fiber to be used is preferably not more than 1000 GPa, more preferably not more than 900 GPa, and further preferably not more than 800 GPa. As the carbon fiber that has such a tensile modulus, a pitch-based carbon fiber can be preferably used. The use of the pitch-based carbon fiber is also preferable in view of the costs. The pitch-based carbon fiber is a carbon fiber obtained from pitch and the PAN-based carbon fiber is a carbon fiber obtained from polyacrylonitrile.

Although carbon fibers can be used alone as the reinforcing fibers for CFRP, carbon fibers can also be used in combination of with glass fibers, aramid fibers, stainless-steal fibers, copper fibers, nickel fibers, titanium fibers, tungsten fibers, silicon carbide fibers, alumina fibers, titanium carbide fibers, boron nitride fibers, or other fibers.

The form of the above-described reinforcing fibers is not specifically limited, but one-dimensional reinforcement, two-dimensional reinforcement, three-dimensional reinforcement, or random reinforcement can be appropriately selected depending on purposes. For example, the reinforcing fibers can be used as short fibers, woven fabrics, non-woven fabrics, unidirectional material, two-dimensional fabrics, three-dimensional fabrics, or the like; and more specifically the lamination of materials, such as felt, matt, knot cloth, Warif, quasi-isotropic material, plain weave, satin fabric, twill weave, mock leno weave and leno weave can also be used.

### [Manufacture of CFRP]

CFRP can be manufactured by normally known methods. For example, the reinforcing fibers processed in the form as described above is impregnated with a thermosetting resin as a matrix resin to form prepreg, and CFRP can be manufactured by further laminating, and curing and shape forming, that is, by cure-shape-forming the prepregs. Above all, it is a preferable manufacturing method to obtain a shaped product having a predetermined tensile modulas by laminating prepregs, in which unidirectional material is used for reinforcing fibers, with appropriately orienting the prepregs in a combination of 0°, ±45°, 90° and the like.

Although heretofore known methods can be appropriately adopted as the method to impregnate the above-described reinforcing fibers with a matrix resin. When a thermosetting resin is used as the matrix resin, a method wherein the reinforcing fibers is impregnated with the resin heated normally to 60°C to 90°C, known as a hot-melt method can be preferably adopted. The content of the matrix resin in the manufactured prepreg is preferably within a range of 20% by mass to 50% by mass, more preferably 25% by mass to 45% by mass to the total quantity of the reinforcing fibers and the matrix resin.

A filler can be added to the matrix resin as desired, and examples of such fillers include mica, alumina, talc, fine silica powder, wollastonite, sepiolite, basic magnesium sulfate, calcium carbonate, polytetrafluoroethylene powder, zinc powder, aluminum powder, and fine organic particles, such as fine acrylic particles, fine epoxy resin particles, fine polyamide particles, and fine polyurethane particles.

The prepreg is finally shaped into CFRP. As the shaping methods, an autoclave shaping method, a sheet rolling shaping method and the like can be used. For example, when a thermosetting resin is used as the matrix resin, the prepreg can be laminated to be a shape suitable for a dummy wafer, and heated and cured in an autoclave or by a press normally at 110°C to 150°C for 30 minutes to 3 hours to form CFRP. The resulting CFRP can have a stable quality and containing few voids.

As the preferred shaping conditions when the above-described epoxy resin composition is used, the heating temperature is 150°C to 200°C, and the curing time is 30 minutes to 2 hours.

Since the dummy wafer requires a high processing accuracy, the resulting CFRP can further be processed into a shape suitable for the dummy wafer using machining or the like.

### [Structure of dummy wafer]

Embodiments of a dummy wafer containing CFRP will be described below in detail referring to the drawings.

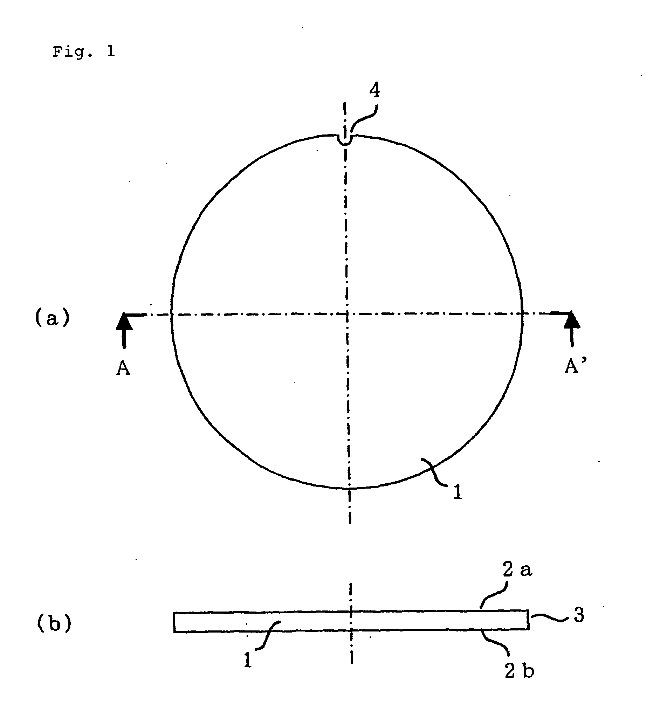

Figure 1 is a schematic view showing an embodiment of a dummy wafer of the present invention, (a) is a top view and (b) is an A-A' sectional view. The dummy wafer is consisits of a wafer substrate 1. The wafer substrate is plate-shaped, specifically disc-shaped, and has a principal surface 2a on the upper surface side, a principal surface 2b on the lower surface side, and an end surface 3, and has a notch 4 for alignment.

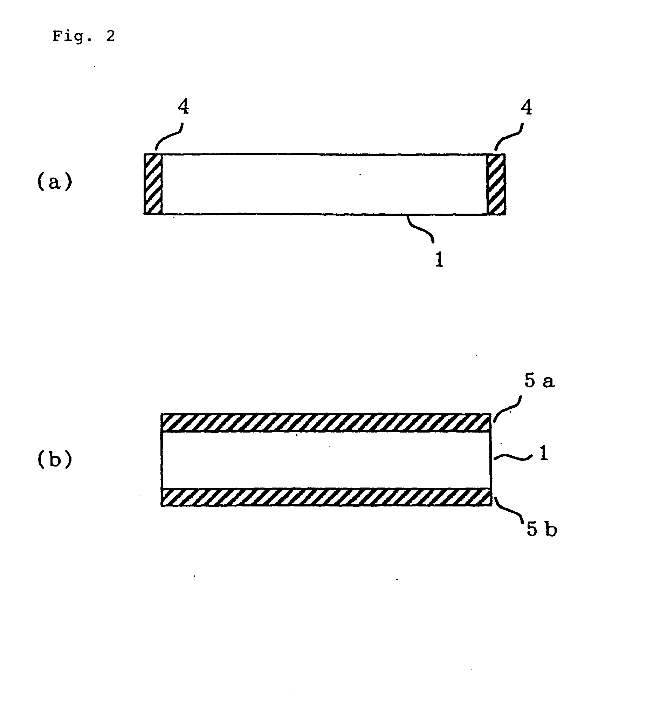

The dummy wafer is not necessarily consists of the wafer substrate alone, but can include, for example, a coating layer for desired purposes, such as dust-generation prevention and scratch prevention. The dummy wafer shown in Figure 2 (a) has a end surface coating layer 4 for coating the end surface on the end surface of the wafer substrate 1. The dummy wafer shown in Figure 2 (b) has principal surface coating layers 5a and 5b for coating each principal surface on the principal surfaces of the wafer substrate 1. There can be various variations wherein, for example, only one principal surface coating layer (5a or 5b) on the wafer substrate 1, or in addition to one or both principal surface coating layers, a end surface coating layer can also be formed. The coating layers can be formed, for example, of a resin. When a notch is formed by machining, the processed surface can be provided with a coating layer. [Wafer substrate]

The wafer substrate can consists of a plate-shaped carbon fiber reinforced plastic (CFRP), or may be a plate-shaped laminate, wherein, for example, layers consists of a plurality of CFRPs (hereafter, a layer consists of CFRP is referred to as a CFRP layer) having the same shape as the intended wafer substrate but being thinner are joined and laminated in the thickness direction. Furthermore, for example, the wafer substrate can also have another layer having the same shape as the wafer substrate but being thinner in addition to a CFRP layer. As another layer, a layer consisting of a resin, and a layer consisting of a fiber reinforced plastic wherein carbon fibers are not major reinforcing fibers are exemplified.

Although the wafer substrate having a plurality of CFRP layers may be a wafer substrate wherein all the CFRP layers of the same shape, size and material are laminated in the same orientation, it is not necessarily required to have such a constitution. One or more of thickness, material and orientation may be different in the plurality of CFRP layers.

For example, in a wafer substrate, CFRP layers of the same shape, size and material may be laminated in different orientations. CFRP has a character that it is difficult to bend in the orientation direction of carbon fibers, and easy to bend in a direction perpendicular thereto. Different orientations of multiple CFRP layers are preferable in that the isotropy of the deflection of the wafer substrate wherein these CFRP layers are laminated is improved.

In addition, for example, there is a configuration wherein the wafer substrate has multiple one-dimensionally reinforced CFRP layers (this layer is a layer consisting of a carbon fiber reinforced plastic made of a cured and shaped product of unidirectional prepreg having carbon fibers oriented in one direction) and the tensile modulus of carbon fibers in a part of layers among the multiple one-dimensionally reinforced CFRP layers is higher than the tensile modulus of carbon fibers in the other layers.

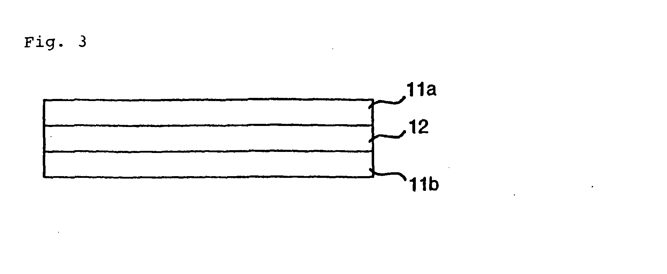

In Figure 3, a wafer substrate having skin layers 11 a and 11 b disposed on two principal surface sides, respectively, and a core layer 12 interposed between them is schematically shown.

In a wafer substrate as shown in Figure 3, for the strength of the dummy wafer against bending, the properties of the skin layer rather than the core layer are important, and in particular, the properties of the outermost layer are important.

In order to obtain a substantially uniform flexural rigidity (since thinner dummy wafers bend more easily from the portions with lower flexural rigidity, uniform flexural properties become more important in thinner dummy wafers), it is further preferable to make the modulus of elasticity of laminated carbon fibers to be different, and it is preferable to use carbon fibers having medium or high modulus of elasticity for the outermost layer of the skin layer (the reinforcing direction, that is the orientation direction of carbon fibers, in the outermost layer is made the reference direction of the dummy wafer), and carbon fibers having higher modulus of elasticity than the outermost layer for the inner layer (it is further preferable that this layer is oriented in a direction different from the reference direction, for example, of 90°). In this description, to indicate angles, counter-clockwise directions are indicated as + directions.

A preferable example of wafer substrate is a dummy wafer wherein
the wafer substrate has two skin layers each located on principal surface side, and a core layer located between said two skin layers;
both of the two skin layers have a plurality of the one-dimensionally reinforced CFRP layers;
when the orientation direction of carbon fibers in one of the two outermost CFRP layers, which are one-dimensionally reinforced CFRP layers located closest to the principal surface side in each of the two skin layers, is made to be a reference direction, the orientation direction of carbon fibers in the other outermost CFRP layer falls within an angle range from -20° to +20° with respect to the reference direction;
the tensile modulus of carbon fibers in both the two outermost CFRP layers is 200 GPa to 600 GPa;
both the two skin layers have a one-dimensionally reinforced CFRP layer containing carbon fibers oriented in an angle range from +75° to +90° with respect to the reference direction and having a tensile modulus of 400 GPa to 1000 GPa and higher than the tensile modulus of carbon fibers in either outermost CFRP layer and/or a one-dimensionally reinforced CFRP layer containing carbon fibers oriented in an angle range from -75° to -90° with respect to the reference direction and having a tensile modulus of 400 GPa to 1000 GPa and higher than the tensile modulus of carbon fibers in either outermost CFRP layer; and
the core layer has a one-dimensionally reinforced CFRP layer containing carbon fibers oriented in an angle range from +30° to +60° with respect to the reference direction and having a tensile modulus of 400 GPa to 1000 GPa, and/or a one-dimensionally reinforced CFRP layer containing carbon fibers oriented in an angle range from -30° to -60° and having a tensile modulus of 400 GPa to 1000 GPa.

Flexural rigidity is the product obtained by multiplying the flexural modulus of the layer by the cube of the distance from the neutral axis and by the thickness of the layer. Thus, the outermost layer is most easily influenced by the distance from the neutral axis. In this regard, the thickness of each of the two skin layers is preferably 10% to 45% the total thickness of the two skin layers and the core layer.

Another preferable configuration is a dummy wafer comprising a wafer substrate including a carbon fiber reinforced plastic, wherein
the wafer substrate has two skin layers each located on principal surface side, and a core layer located between the two skin layers;
both of the two skin layers have a plurality of one-dimensionally reinforced CFRP layers, said one-dimensionally reinforced CFRP layer being a layer consisting of carbon fiber reinforced plastic consisting of a cured and shaped product of a unidirectional prepreg in which carbon fibers are oriented in one direction;
when the orientation direction of carbon fibers in one of the two outermost CFRP layers, which are one-dimensionally reinforced CFRP layers located closest to the principal surface side in each of said two skin layers, is made to be a reference direction, the orientation direction of carbon fibers in the other outermost CFRP layer falls within an angle range from -20° to +20° with respect to the reference direction;
the tensile modulus of carbon fibers in both the two outermost CFRP layers is 200 GPa to 600 GPa;
both the two skin layers have a one-dimensionally reinforced CFRP layer containing carbon fibers oriented in an angle range from +75° to +90° with respect to the reference direction and having a tensile modulus 1.5 times to 3.0 times that of carbon fibers of the outermost CFRP layer contained in the skin layer, and/or a one-dimensionally reinforced CFRP layer containing carbon fibers oriented in an angle range from -75° to -90° with respect to the reference direction and having a tensile modulus 1.5 times to 3.0 times that of carbon fibers of the outermost CFRP layer contained in the skin layer;
the core layer has a one-dimensionally reinforced CFRP layer containing carbon fibers oriented in an angle range from -20° to +20° with respect to the reference direction and having a tensile modulus of 200 GPa to 400 GPa; and
the core layer also has a one-dimensionally reinforced CFRP layer containing carbon fibers oriented in an angle range from +75° to +90° with respect to the reference direction and having a tensile modulus of 200 GPa to 400 GPa and/or a one-dimensionally reinforced CFRP layer containing carbon fibers oriented in an angle range from -75° to -90° with respect to the reference direction and having a tensile modulus of 200 GPa to 400 GPa.

In this dummy wafer, it is preferable that at least one of the two skin layers further has a one-dimensionally reinforced CFRP layer containing carbon fibers oriented in an angle range from +30° to +60° with respect to the reference direction and having a tensile modulus 1.5 times to 3.0 times that of carbon fibers of the outermost CFRP layer contained in the skin layer, and/or a one-dimensionally reinforced CFRP layer containing carbon fibers oriented in an angle range from -30° to -60° with respect to the reference direction and having a tensile modulus 1.5 times to 3.0 times that of carbon fibers of the outermost CFRP layer contained in the skin layer.

In the dummy wafer of the above-described configurations, it is preferable that the dummy wafer further has a carbon fiber cloth layer on each of the principal surfaces in the view point of preventing the front layer from peeling off in machining.

### [Manufacture of wafer substrate]

The wafer substrate can be manufactured, for example, by machining a plate-like CRFP to form a desired shape, such as a circle. Alternatively, the wafer substrate can be manufactured by joining multiple plate-like CFRPs as required to form an integrated plate-like member having a desired thickness, and machining it to form a desired shape. Furthermore, the wafer substrate can be manufactured by joining one or more plate-like CFRPs in combination with a plate-like member made of other material to form an integrated plate-like member, and machining it to form a desired shape.

### [SEMI Standards]

For silicon wafers, for example, SEMI M1.14-95 specifies the guideline of a mirror-surface single crystalline silicon wafer of a diameter of 300 mm to 400 mm. The required conditions for dimensions and tolerance described in this guideline are summarized in Table 1.

Although the shape and size of the dummy wafer used in place of such a silicon wafer should be the same as the shape and size of the silicon wafer, the thickness thereof is as thin as 0.8 mm as shown in Table 1, and in some cases, further thin wafers as 0.5 mm are required. In order to manufacture such a thin dummy wafer, it is preferable that many thin prepreg sheets are laminated. This is because a degree of freedom on the design of a dummy wafer can be obtained by using multiple prepregs, and for example, a dummy wafer that meets the required dimension, tolerance and the like specified in SEMI Standards can be easily obtained. It is particularly preferable to change the orientation of the multiple prepreg sheets to form quasi isotropic lamination (for example a combination of 0/90/45°), and also to adequately change the modulus of elasticity of respective reinforcing fibers. This is because the anisotropy of the flexural rigidity of CFRP can be eliminated. For these purposes, it is preferable to manufacture CFRP using a prepreg sheet having a thickness of 100 µm or less. It is more preferable that the thickness of all the prepreg sheets used for manufacturing CFRP is 30 µm to 100 µm.

**Table 1**

| Property | Dimension | Dimension | Dimension | Allowance | Unit |
|---|---|---|---|---|---|
| Diameter | 300.00 | 350.00 | 400.00 | ±0.25 | mm |
| Center thickness | 775 | 800 | 825 | ±25 | µm |
| Notch standards | | | | | |
| Depth | 1.00 | 1.00 | 1.00 | +0.25, -0.00 | mm |
| Angle | 90 | 90 | 90 | +5, -1 | degrees |
| Bow (max.) | 65 | 65 | 65 | | µm |
| Warp (max.) | 75 | 75 | 75 | | µm |
| Total thickness change (GBIR) (max.) | 25 | 25 | 25 | | µm |
| Edge shape coordinate: Cy | 258 | 267 | 275 | | µm |
| Nominal weight of wafer | 128 | 179 | 242 | | g |

### [Coating of processed surface]

When the wafer substrate has a processed surface, it is preferable that the processed surface is coated by a resin that has resistance to polar solvents, and cures at a low temperature of 70°C or lower (hereafter referred to as a coating resin). The term "processed surface" used herein means the portion on which carbon fibers in CFRP are exposed by processing, such as machining, and specifically, a cut surface, a polished surface, a rounded surface, a holed surface, a thinned surface and the like are included. For example, when the end surface of a wafer substrate is a processed surface formed by machining, it is preferable that the end surface is provided with a coating layer as Figure 2 (a) shows. By coating the processed surface, contamination by carbon from the processed surface can be prevented, and a dummy wafer treated so as to be hard to contaminate precision equipment materials can be obtained while utilizing the lightness and high rigidity originally possessed by the CFRP dummy wafer. In addition, this coating has the effect of protecting the end surface, such as the prevention of scratches.

Examples of coating resins include an acrylic resin, an ultraviolet-curing epoxy resin, an epoxy resin that cures at room temperature to medium temperature, a moisture-curing silicone resin, and the mixture of two or more resins selected from these resins.

For example, the mixing mass ratio of two kinds of resins selected from these resins is preferably 1:0.05 to 0.05:1.

Resistance of a resin against a polar solvent means that even if the resin-applied surface is wiped with cloth soaked by a polar solvent, the applied surface is not easily dissolved, swollen, or does not become sticky, and dirt or dust derived from carbon fibers, such as fine carbon particles does not substantially fly from the dummy wafer, and furthermore, the cloth used for wiping the resin-applied surface is not substantially contaminated by fine carbon particles or the like.

A polar solvent is an acetone-based or alcohol-based solvent or the like, for example, acetone, diethyl ketone, methyl ethyl ketone, methanol, ethanol, isopropyl alcohol, the mixture thereof and the like.

The above-described acrylic resins include polyester acrylate, urethane acrylate, polyether acrylate, epoxy acrylate, polybutadiene acrylate, silicone acrylate, acryl acrylate, the mixture thereof and the like.

By adding a peroxide for room-temperature curing or a catalyst for ultraviolet curing to the coating resin, the resin can be cured at room temperature or by ultraviolet irradiation.

The epoxy resin that cures at room temperature to medium temperature means an epoxy resin that cures normally at 10°C to 90°C, preferably at 20°C to 80°C. If the resin cures at 90°C or below, the thermal deformation of CFRP members can be prevented. As the above-described epoxy resin that cures at room temperature to medium temperature, an epoxide reaction product of an alicyclic amine and/or an aromatic amine with an epoxy resin can be preferably used.

As the above-described ultraviolet-curing epoxy resin, for example, a liquid bis-phenol epoxy resin, an alicyclic epoxy resin, or a mixture thereof can be used. An aromatic diazonium salt, an aromatic iodonium salt, an aromatic sulfonium salt, a metallocene compound, or a mixture thereof can be added to the ultraviolet-curing epoxy resin as a curing catalyst.

As the above-described silicone resin, an alkyd-modified silicone resin, an epoxy-modified silicone resin, a moisture-curing alcohol silicone resin, a moisture-curing oxime silicone resin, or an addition-reaction silicone resin can be used. The moisture-curing alcohol silicone resin or the moisture-curing oxime silicone resin are preferably used.

As the above-described moisture-curing alcohol-type silicone resin, for example, SR 2410, SR 2406, SR 2420, and SR 2416 (trade names, manufactured by Dow Corning Toray Silicone Co., Ltd.), and KE 4895 (trade name, manufactured by Shin-Etsu Chemical Co., Ltd.) can be used.

As the curing catalyst for the above-described moisture-curing alcohol silicone resin, dibutyl tin diacetate, dibutyl tin dilaurate, or a mixture thereof can be used.

As the above-described moisture-curing oxime silicone resin, for example, SR 2405 and SR 2411 (trade names, manufactured by Dow Corning Toray Silicone Co., Ltd.), and KE 445 (trade name, manufactured by Shin-Etsu Chemical Co., Ltd.) can be used.

As the curing catalyst for the above-described moisture-curing oxime silicone resin, dibutyl tin diacetate, dibutyl tin dilaurate, or a mixture thereof can be used as in the case of the moisture-curing alcohol silicone resin.

As a coating method, a method wherein a coating resin diluted to 5 parts by mass to 60 parts by mass with a solvent is applied onto the processed surface of a dummy wafer, and the applied resin is heated and cured at 70°C or below, is preferably used. By using this method, a dummy wafer having resistance against polar solvents, and whose processed surface is coated with a resin that cured at a low temperature of 70°C or below (coating resin) can be obtained. By making the concentration of the coating resin diluted with a solvent be 5 parts by mass or above, the thinning of the coating film obtained by applying the diluted coating resin onto the processed surface can be prevented; and by making it be 60 parts by mass or below, the occurrence of concavity and convexity on the surface of the member due to uneven coating after the applied coating resin has cured can be excellently prevented.

The method for applying the coating resin is not specifically limited. Any methods can be appropriately used as long as the coating resin can be coated on the processed surface of the dummy wafer, and brushing, spraying, roll-coating or the like can be adopted.

The thickness of the coating layer obtained by applying and curing the coating resin diluted with a solvent can be, for example, 5 µm to 30 µm. By making the thickness be 30 µm or below, the consumption of a long time for drying can be prevented, and dripping or unevenness can be excellently prevented. On the other hand, by making the thickness be 5 µm or above, the effect of coating can be well obtained.

The curing temperature of the above-described coating resin is preferably 20°C to 70°C, and by curing at 70°C or below, the warp or deformation of the dummy wafer due to heat can be excellently prevented during curing.

### Example 1 Lamination forming of dummy wafer

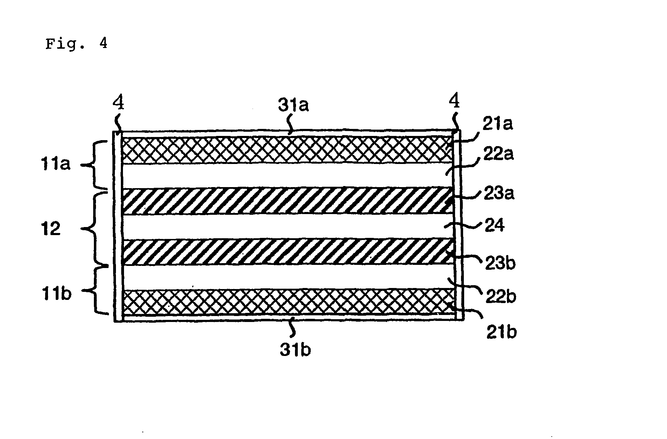

A dummy wafer shown in Figure 4 was fabricated using the procedures described below:

### (1) Manufacture of resin composition for composite material

As a bis-phenol-A epoxy resin, 30 parts by mass of Epotohto YD 128 (trade name, manufactured by Tohto Kasei Co., Ltd.), as a phenol novolak epoxy resin, 50 parts by mass of Epotohto YDPN 638 (trade name, manufactured by Tohto Kasei Co., Ltd.), and as a phenoxy resin, 10 parts by mass of Phenotohto YP 50 (trade name, manufactured by Tohto Kasei Co., Ltd.) were mixed at 200°C for 1.5 hours, and cooled to 90°C. To this mixture, 20 parts by mass of Epotohto YH 434 (trade name, manufactured by Tohto Kasei Co., Ltd.), which is a glycidyl-amine epoxy resin, and 40 parts by mass of 4,4'-diaminodiphenyl sulfone (DDS) (trade name: Seikacure S, manufactured by Wakayama Kasei Kogyou Co. Ltd.), which is a curing agent. are evenly mixed under a vacuum degassing to obtain a heat-resistant epoxy resin composition, and the mixture was transferred to another vessel and cooled.

### (2) Fabrication of skin layer

A skin layer having a thickness of 0.156 mm was fabricated by laminating one unidirectional prepreg sheet obtained by drawing and aligning pitch-based carbon fibers having a tensile modulus of 800 GPa in one direction and impregnating them with the epoxy resin composition obtained in the above (1) (fiber mass per unit area: 70 g/m², resin content: 38% by mass, thickness: 0.067 mm) so that the reinforcing direction thereof becomes 90° direction with respect to the reference direction of the dummy wafer; and one unidirectional prepreg sheet obtained by drawing and aligning PAN-based carbon fibers having a tensile modulus of 230 GPa in one direction and impregnating them with the epoxy resin composition obtained in the above (1) (fiber mass per unit area: 85 g/m², resin content: 38% by mass, thickness: 0.089 mm) (the reinforcing direction becomes the reference direction of the dummy wafer, i.e. 0° direction); and curing the laminate in an autoclave. The percentage by volume of the cured and shaped product of the former prepreg, in which the pitch-based carbon fibers were used, in the skin layer was 43%, and the balance 57% was the cured and shaped product of the latter prepreg in which the PAN-based carbon fibers were used. When the dummy wafer is completed, the prepreg sheets containing the pitch-based carbon fibers become CFRP layers 22a and 22b containing pitch-based carbon fibers, and the prepreg sheets containing the PAN-based carbon fibers become CFRP layers 21 a and 21 b containing PAN-based carbon fibers (these become the outermost CFRP layer).

### (3) Fabrication of core layer

There were used unidirectional prepreg sheets obtained by drawing and aligning pitch-based carbon fibers having a tensile modulus of 600 GPa in one direction and impregnating the fibers with the above-described epoxy resin composition (fiber mass per unit area: 50 g/m², resin content: 38% by mass, thickness: 0.048 mm) and a glass-fiber woven prepreg sheet obtained by impregnating a woven glass-fiber having glass fibers in the two orthogonal direction with the epoxy resin composition obtained in the above (1) (fiber mass per unit area: 80 g/m², resin content: 35% by mass, thickness: 0.066 mm). One of the unidirectional prepreg sheets that had pitch-based carbon fibers of a tensile modulus of 600 GPa was first laminated so that the reinforcing direction thereof became +45° with respect to the reference direction of the dummy wafer, and then, one of the above-described unidirectional prepreg sheets that had pitch-based carbon fibers of a tensile modulus of 600 GPa was laminated so that the reinforcing direction thereof became -45° with respect to the reference direction of the dummy wafer. Further thereon, the above-described glass-fiber woven prepreg sheet was laminated so that one of the reinforcing directions thereof agreed with the reference direction of the dummy wafer. Finally thereon, one of the unidirectional prepreg sheets that had pitch-based carbon fibers of a tensile modulus of 600 GPa was first laminated so that the reinforcing direction thereof became -45° with respect to the reference direction of the dummy wafer, and then, one of the above-described unidirectional prepreg sheets that had pitch-based carbon fibers of a tensile modulus of 600 GPa was laminated so that the reinforcing direction thereof became +45° with respect to the reference direction of the dummy wafer; and the laminate was cured in an autoclave to fabricate a core layer of a thickness of 0.258 mm.

The percentage by volume of the cured and shaped product of the former prepregs, in which the pitch-based carbon fibers were used, in the core layer was 74%, and the balance 26% was the cured and shaped product of the latter prepreg in which glass fibers were used. When the dummy wafer is completed, laminates of the prepreg sheets containing the pitch-based carbon fibers become CFRP layers 23a and 23b containing pitch-based carbon fibers, and the prepreg sheet containing glass fibers becomes glass-fiber reinforced plastic layer 24 containing glass fibers.

### (4) Fabrication of wafer substrate

Two skin layers as described above were prepared, the above-described core layer was interposed and joined between the skin layers, and carbon-fiber fabrics (satin fabrics, thickness: 0.1 mm) each having a tensile modulus of 230 GPa were laminated on the surfaces of the both skin layers, respectively, to form carbon-fiber cloth layers, to obtain a CFRP plate of a thickness of 0.770 mm. When the dummy wafer is completed, the cloth layers become carbon-fiber cloth layers 31 a and 31 b. From the CFRP plate, a disc-shaped wafer substrate of a diameter of 300 mm was obtained by machining. The orientation directions of the carbon fibers in the outermost CFRP layers present in the two skin layers were matched to each other.

### (5) Resin coating treatment of processed surface

After wiping the end portion of the above-described disc-shaped CFRP plate, which was a processed surface, with clean cloth (polyester knit) free of duct soaked with ethanol, a moisture-curing alcohol silicone coating agent, SR 2419 (trade name, manufactured by Dow Corning Toray Silicone Co., Ltd., resin content: 20 parts by mass, solvent: ligroin) was applied to the above-described processed surface using a brush. After drying the applied silicone coating agent, it was cured in a drying furnace at 50°C for 1 hour to further accelerate the cure of the coating agent to form a coating layer 4 to obtain a dummy wafer.

At this time, no unevenness or irregularity of the applied surface was observed. Thereafter, the applied surface was sufficiently wiped using clean cloth (polyester knit) free of duct soaked with ethanol, and no contamination of the coating-resin applied surface of the end portion of the dummy wafer and the clean cloth was observed.

### (6) Test of mechanical properties (uniformity of flexural rigidity)

Strip test specimens of 20 mm wide × 80 mm long (× 0.770 mm thick) were cut out of the above described dummy wafer. Two kinds of cutting directions of the test specimens were a direction wherein the reference direction of the dummy wafer agreed to the length direction of the above described test specimen (0° test specimen), and a direction wherein the 90° to the reference direction of the dummy wafer agreed to the length direction of the above described test specimen (90° test specimen). Using the above described test specimens, flexural moduli were measured by the three-point flexural test. The distance between fulcrums in the three-point flexural test was 60 mm.

As Table 2 shows, the dummy wafer in Example 1 had isotropy, wherein difference in flexural moduli between the reference direction and 90° to the reference direction was small.

### (7) Test of planarity

At the center of the above-described dummy wafer, and at points of every 15° on circumferences on 30 mm, 60 mm, 90 mm, 120 mm and 150 mm (the circumference of the dummy wafer) from the center in the radial direction, the thicknesses of the dummy wafer were measured. The number of points where the thicknesses were measured was 121. The difference between the maximum thickness and the minimum thickness was 0.02 mm, and the dummy wafer of Example 1 had an even thickness.

### (8) Heat resistance

A graphite plate of substantially the same shape as the dummy wafer (a mass of 1 kg) was placed on the above-described dummy wafer, and was subjected to 50 cycles of thermal shock tests wherein the dummy wafer was placed in an electric furnace in the atmosphere at 200°C for 10 minutes, and thereafter taken out and cooled in the air for 10 minutes at room temperature. As a result, no abnormality, such as warp and delamination occurred. Furthermore, no change in the mass before and after the test occurred.

### (9) Outgas test

Outgas properties were evaluated under a condition of a vacuum of 7.0 x 10⁻³ Pa or below. The dummy wafer of Example 1 had favorable outgas properties for both the mass loss and the re-condensate mass ratio.

### Example 2

### (1) Structure of resin composition for composite material

An epoxy resin composition was fabricated in the same manner as in Example 1.

### (2) Fabrication of dummy wafer

There were used three kinds of unidirectional prepreg sheets: a unidirectional prepreg sheet obtained by drawing and aligning pitch-based carbon fibers having a tensile modulus of 500 GPa in one direction and impregnating them with the epoxy resin composition obtained in the above (1) (fiber mass per unit area: 50 g/m², resin content: 38% by mass, thickness: 0.048 mm); a unidirectional prepreg sheet obtained by drawing and aligning pitch-based carbon fibers having a tensile modulus of 800 GPa in one direction and impregnating them with the epoxy resin composition obtained in the above (1) (fiber mass per unit area: 50 g/m², resin content: 38% by mass, thickness: 0.048 mm); and a unidirectional prepreg sheet obtained by drawing and aligning PAN-based carbon fibers having a tensile modulus of 230 GPa in one direction and impregnating them with the epoxy resin composition obtained in the above (1) (fiber mass per unit area: 45 g/m², resin content: 38% by mass, thickness: 0.047 mm).

As skin layers, the unidirectional prepreg sheets having pitch-based carbon fibers of a tensile modulus of 500 GPa, and the unidirectional prepreg sheets having pitch-based carbon fibers of a tensile modulus of 800 GPa were used; as a core layer, the unidirectional prepreg sheets having PAN-based carbon fibers of a tensile modulus of 230 GPa were used; and after laminating unidirectional prepreg sheets used for the skin layers and the core layer, the wafer substrate having the skin layers and the core layer was integrally shaped.

With regard to the laminating order, first, one unidirectional prepreg sheet having pitch-based carbon fibers of a tensile modulus of 500 GPa (the reinforcing direction thereof becomes the reference direction of the dummy wafer) was disposed, and thereon, unidirectional prepreg sheets having pitch-based carbon fibers of a tensile modulus of 800 GPa were laminated so that the reinforcing direction of each sheet becomes sequentially 90°, +45°, and -45° to the reference direction of the dummy wafer, respectively.

Next, one unidirectional prepreg sheet having PAN-based carbon fibers of a tensile modulus of 230 GPa was laminated thereon so that the reinforcing direction thereof becomes the reference direction of the dummy wafer; two unidirectional prepreg sheets each having PAN-based carbon fibers of a tensile modulus of 230 GPa were laminated thereon so that the reinforcing directions thereof are perpendicular to the reference direction of the dummy wafer; and further one unidirectional prepreg sheet having PAN-based carbon fibers of a tensile modulus of 230 GPa was laminated thereon so that the reinforcing direction thereof becomes the reference direction of the dummy wafer.

Further thereon, unidirectional prepreg sheets each having pitch-based carbon fibers of a tensile modulus of 800 GPa were laminated so that the reinforcing direction of each sheet becomes sequentially -45°, +45°, and 90° to the reference direction of the dummy wafer, respectively; and finally thereon, one unidirectional prepreg sheet having pitch-based carbon fibers of a tensile modulus of 500 GPa was laminated so that the reinforcing direction thereof becomes the reference direction of the dummy wafer.

Accordingly, the laminated constitution of the dummy wafer according to Example 2 has, in the order from one principal surface, (500 GPa, 0°, one layer), (800 GPa, 90°, one layer), (800 GPa, +45°, one layer), (800 GPa, -45°, one layer), (230 GPa, 0°, one layer), (230 GPa, 90°, two layers), (230 GPa, 0°, one layer), (800 GPa, -45°, one layer), (800 GPa, +45°, one layer), (800 GPa, 90°, one layer), and (500 GPa, 0°, one layer). Here, (500 GPa, 0°, one layer) indicates that there is one layer of a one-dimensionally reinforced CFRP layer wherein carbon fibers of a tensile modulus of 500 GPa is oriented to the 0° direction (the same applies to the following).

In the same manner as in Example 1, a carbon-fiber cloth layer was disposed on each principal surface of the above-described prepreg laminate, the laminate was cured in an autoclave to obtain a disc-shaped wafer substrate of a thickness of 0.772 mm and a diameter of 300 mm from the CFRP plate.

A dummy wafer was fabricated in the same manner as in Example 1, except that this wafer substrate was used.

### (3) Test of mechanical properties

Strip test specimens of 20 mm wide × 80 mm long (× 0.772 mm thick) were cut out of the above described dummy wafer. Two kinds of cutting directions of the test specimens were a direction wherein the reference direction of the dummy wafer agreed to the length direction of the above described test specimen (0° test specimen), and a direction wherein the 90° to the reference direction of the dummy wafer agreed to the length direction of the above described test specimen (90° test specimen). Using the above described test specimens, flexural moduli were measured by the three-point flexural test. The distance between fulcrums in the three-point flexural test was 60 mm.

As Table 1 shows, the dummy wafer in Example 2 had isotropy, wherein difference in flexural moduli between the reference direction and 90° to the reference direction was small.

### (4) Change in thickness

At the center of the above-described dummy wafer, and at points of every 15° on circumferences on 30 mm, 60 mm, 90 mm, 120 mm and 150 mm (the circumference of the dummy wafer) from the center in the radial direction, the thicknesses of the dummy wafer were measured. The number of points where the thicknesses were measured was 121. The difference between the maximum thickness and the minimum thickness was 0.02 mm, and the dummy wafer of Example 2 had an even thickness.

### (5) Heat resistance

A graphite plate of substantially the same shape as the dummy wafer (a mass of 1 kg) was placed on the above-described dummy wafer, and was subjected to 50 cycles of thermal shock tests wherein the dummy wafer was placed in an electric furnace in the atmosphere at 200°C for 10 minutes, and thereafter taken out of the furnace and cooled in the air for 10 minutes at room temperature. As a result, no abnormality, such as warp and delamination occurred. Furthermore, no change in the mass before and after the test occurred.

### (6) Outgas test

Outgas properties were evaluated under a condition of a vacuum of 7.0 × 10⁻³ Pa or below. The dummy wafer of Example 2 had favorable outgas properties for both the mass loss and the re-condensate mass ratio.

### Example 3

### (1) Manufacture of resin composition for composite material

An epoxy resin composition was fabricated in the same manner as in Example 1.

### (2) Fabrication of dummy wafer

There were used three kinds of unidirectional prepreg sheets: a unidirectional prepreg sheet obtained by drawing and aligning PAN-based carbon fibers having a tensile modulus of 230 GPa in one direction and impregnating them with the epoxy resin composition obtained in the above (1) (fiber mass per unit area: 50 g/m², resin content: 38% by mass, thickness: 0.052 mm); a unidirectional prepreg sheet obtained by drawing and aligning PAN-based carbon fibers having a tensile modulus of 380 GPa in one direction and impregnating them with the epoxy resin composition obtained in the above (1) (fiber mass per unit area: 45 g/m², resin content: 38% by mass, thickness: 0.047 mm); and a unidirectional prepreg sheet obtained by drawing and aligning PAN-based carbon fibers having a tensile modulus of 230 GPa in one direction and impregnating them with the epoxy resin composition obtained in the above (1) (fiber mass per unit area: 45 g/m², resin content: 38% by mass, thickness: 0.047 mm).

As skin layers, the prepreg sheets of a thickness of 0.052 mm among the unidirectional prepreg sheets having PAN-based carbon fibers of a tensile modulus of 230 GPa, and the unidirectional prepreg sheets having PAN-based carbon fibers of a tensile modulus of 380 GPa were used; as a core layer, the unidirectional prepreg sheets of a thickness of 0.047 mm among the unidirectional prepreg sheets having PAN-based carbon fibers of a tensile modulus of 230 GPa were used; and after laminating the unidirectional prepreg sheets used for the above-described skin layers and core layer, the wafer substrate having the skin layers and the core layer was integrally shaped.

With regard to the laminating order, first, one prepreg sheet of a thickness of 0.052 mm (the reinforcing direction thereof becomes the 0° direction of the dummy wafer) among the unidirectional prepreg sheets having PAN-based carbon fibers of a tensile modulus of 230 GPa was disposed, and thereon, unidirectional prepreg sheets having PAN-based carbon fibers of a tensile modulus of 380 GPa were laminated so that the reinforcing direction of each sheet becomes sequentially 90°, +45°, and -45° to the 0° direction of the dummy wafer, respectively.

Next, one prepreg sheet of a thickness of 0.047 mm among the unidirectional prepreg sheets having PAN-based carbon fibers of a tensile modulus of 230 GPa was laminated thereon so that the reinforcing direction thereof becomes the 0° direction of the dummy wafer; two prepreg sheets of a thickness of 0.047 mm among the unidirectional prepreg sheets each having PAN-based carbon fibers of a tensile modulus of 230 GPa were laminated thereon so that the reinforcing directions thereof are perpendicular to the 0° direction of the dummy wafer; and further one prepreg sheet of a thickness of 0.047 mm among the unidirectional prepreg sheets having PAN-based carbon fibers of a tensile modulus of 230 GPa was laminated thereon so that the reinforcing direction thereof becomes the 0° direction of the dummy wafer.

Further thereon, unidirectional prepreg sheets each having PAN-based carbon fibers of a tensile modulus of 380 GPa were laminated so that the reinforcing direction of each sheet becomes sequentially -45°, +45°, and 90° to the 0° direction of the dummy wafer, respectively; and finally thereon, one prepreg sheet of a thickness of 0.052 mm among the unidirectional prepreg sheets having PAN-based carbon fibers of a tensile modulus of 230 GPa was laminated so that the reinforcing direction thereof becomes the 0° direction of the dummy wafer.

Accordingly, the laminated constitution of the dummy wafer according to Example 3 has, in the order from one principal surface, (230 GPa, 0°, one layer), (380 GPa, 90°, one layer), (380 GPa, +45°, one layer), (380 GPa, -45°, one layer), (230 GPa, 0°, one layer), (230 GPa, 90°, two layers), (230 GPa, 0°, one layer), (380 GPa, -45°, one layer), (380 GPa, +45°, one layer), (380 GPa, 90°, one layer), and (230 GPa, 0°, one layer).

In the same manner as in Example 1, a carbon-fiber cloth layer was disposed on each principal surface of the above-described prepreg laminate, and the laminate was cured in an autoclave to obtain a disc-shaped wafer substrate of a thickness of 0.774 mm and a diameter of 300 mm from the CFRP plate.

A dummy wafer was fabricated in the same manner as in Example 1, except that this wafer substrate was used.

### (3) Test of mechanical properties

Strip test specimens of 20 mm wide × 80 mm long (× 0.774 mm thick) were cut out of the above described dummy wafer. Two kinds of cutting directions of the test specimens were a direction wherein the reference direction of the dummy wafer agreed to the length direction of the above described test specimen (0° test specimen), and a direction wherein the 90° to the reference direction of the dummy wafer agreed to the length direction of the above described test specimen (90° test specimen). Using the above described test specimens, flexural moduli were measured by the three-point flexural test. The distance between fulcrums in the three-point flexural test was 60 mm.

As Table 2 shows, the dummy wafer in Example 2 had isotropy, wherein difference in flexural moduli between the reference direction and 90° to the reference direction was small.

### (4) Change in thickness

At the center of the above-described dummy wafer, and at points of every 15° on circumferences on 30 mm, 60 mm, 90 mm, 120 mm and 150 mm (the circumference of the dummy wafer) from the center in the radial direction, the thicknesses of the dummy wafer were measured. The number of points where the thicknesses were measured was 121. The difference between the maximum thickness and the minimum thickness was 0.02 mm, and the dummy wafer of Example 3 had an even thickness.

### (5) Heat resistance

A graphite plate of substantially the same shape as the dummy wafer (a mass of 1 kg) was placed on the above-described dummy wafer, and was subjected to 50 cycles of thermal shock tests wherein the dummy wafer was placed in an electric furnace in the atmosphere at 200°C for 10 minutes, and thereafter taken out of the furnace and cooled in the air for 10 minutes at room temperature. As a result, no abnormality, such as warp and delamination occurred. Furthermore, no change in the mass before and after the test occurred.

### (6) Outgas test

Outgas properties were evaluated under a condition of a vacuum of 7.0 × 10⁻³ Pa or below. The dummy wafer of Example 3 had favorable outgas properties for both the mass loss and the re-condensate mass ratio.

### Example 4

### (1) Manufacture of resin composition for composite material

An epoxy resin composition was fabricated in the same manner as in Example 1.

### (2) Fabrication of dummy wafer

Unidirectional prepreg sheets obtained by drawing and aligning PAN-based carbon fibers of a tensile modulus of 230 GPa in one direction and impregnating them with the epoxy resin composition obtained in the above (1) (fiber mass per unit area: 70 g/m², resin content: 37% by mass, thickness: 0.072 mm) were used.

With regard to the laminating order, the total of 8 above-described unidirectional prepreg sheets having PAN-based carbon fibers of a tensile modulus of 230 GPa were laminated so that the reinforcing direction of each sheet becomes sequentially 0°, 90°, +45°, -45°, -45°, +45°, 90°, and 0° to the reference direction of the dummy wafer, respectively.

In the same manner as in Example 1, a carbon-fiber cloth layer was disposed on each principal surface of the above-described prepreg laminate, the laminate was cured in an autoclave to obtain a disc-shaped wafer substrate of a thickness of 0.776 mm and a diameter of 300 mm from the CFRP plate.

A dummy wafer was fabricated in the same manner as in Example 1, except that this wafer substrate was used, and no coating layer was provided on the processed surface.

When the processed surface was wiped using clean cloth free of dust soaked with ethanol as in Example 1, black dirt was observed on the clean cloth. No such a phenomenon was found on surfaces other than the processed surface.

### (3) Test of mechanical properties

Strip test specimens of 20 mm wide × 80 mm long (× 0.776 mm thick) were cut out of the above described dummy wafer. Two kinds of cutting directions of the test specimens were a direction wherein the reference direction of the dummy wafer agreed to the length direction of the above described test specimen (0° test specimen), and a direction wherein the 90° direction to the reference direction of the dummy wafer agreed to the length direction of the above described test specimen (90° test specimen). Using the above described test specimens, flexural moduli were measured by the three-point flexural test. The distance between fulcrums in the three-point flexural test was 60 mm.

As Table 1 shows, in the dummy wafer in Example 4, difference in flexural moduli between the reference direction and 90° to the reference direction was large compared with Examples 1 to 3, and anisotropy in rigidity was observed. However, the dummy wafer still had rigidity usable as a dummy wafer.

**Table 2**

| Mechanical property test | | | | |
|---|---|---|---|---|
| | Example 1 | Example 2 | Example 3 | Example 4 |
| 0° direction flexural modulus GPa | 73 | 87 | 62 | 63 |
| 90° direction flexural modulus GPa | 68 | 85 | 63 | 50 |

### Industrial Applicability

According to the present invention, there was provided a dummy wafer that was rigid and had high strength, was relatively inexpensive, and easily responded to light sensors. Furthermore, a dummy wafer that produced little dust, and dummy wafer that had heat resistance were provided.

## Claims

1. A dummy wafer comprising a carbon fiber reinforced plastic.

2. The dummy wafer according to claim 1 having a wafer substrate including a carbon fiber reinforced plastic.

3. The dummy wafer according to claim 2, wherein said carbon fiber reinforced plastic includes carbon fibers having a tensile modulus of 400 GPa or higher.

4. The dummy wafer according to claim 3, wherein said carbon fibers are pitch-based carbon fibers.

5. The dummy wafer according to claim 2, wherein said wafer substrate has a plurality of CFRP layers which are layers consisting of a carbon fiber reinforced plastic.

6. The dummy wafer according to claim 5, wherein said wafer substrate has a plurality of one-dimensionally reinforced CFRP layers, said one-dimensionally reinforced CFRP layer being a layer consisting of a carbon fiber reinforced plastic consisting of a cured and shaped product of a unidirectional prepreg in which carbon fibers are oriented in one direction, and
the tensile modulus of the carbon fibers in a part of layers among said plurality of one-dimensionally reinforced CFRP layers is higher than the tensile modulus of the carbon fiber in the other layers.

7. The dummy wafer according to claim 6, wherein
said wafer substrate has two skin layers each located on principal surface side, and a core layer located between said two skin layers;
both of said two skin layers have a plurality of said one-dimensionally reinforced CFRP layers;
when the orientation direction of carbon fibers in one of the two outermost CFRP layers, which are one-dimensionally reinforced CFRP layers located closest to the principal surface side in each of said two skin layers, is made to be a reference direction, the orientation direction of carbon fibers in the other outermost CFRP layer falls within an angle range from -20° to +20° with respect to the reference direction;
the tensile modulus of carbon fibers in both the two outermost CFRP layers is 200 GPa to 600 GPa;
both the two skin layers have a one-dimensionally reinforced CFRP layer containing carbon fibers oriented in an angle range from +75° to +90° with respect to the reference direction and having a tensile modulus of 400 GPa to 1000 GPa and higher than the tensile modulus of carbon fibers in either outermost CFRP layer and/or a one-dimensionally reinforced CFRP layer containing carbon fibers oriented in an angle range from -75° to -90° with respect to the reference direction and having a tensile modulus of 400 GPa to 1000 GPa and higher than the tensile modulus of carbon fibers in either outermost CFRP layer; and
said core layer has a one-dimensionally reinforced CFRP layer containing carbon fibers oriented in an angle range from +30° to +60° with respect to the reference direction and having a tensile modulus of 400 GPa to 1000 GPa, and/or a one-dimensionally reinforced CFRP layer containing carbon fibers oriented in an angle range from -30° to -60° and having a tensile modulus of 400 GPa to 1000 GPa.

8. The dummy wafer according to claim 7, wherein the thickness of each of said two skin layers is 10% to 45% the total thickness of said two skin layers and the core layer.

9. A dummy wafer comprising a wafer substrate including a carbon fiber reinforced plastic, wherein
said wafer substrate has two skin layers each located on principal surface side, and a core layer located between said two skin layers;
both of said two skin layers have a plurality of one-dimensionally reinforced CFRP layers, said one-dimensionally reinforced CFRP layer being a layer consisting of a carbon fiber reinforced plastic consisting of a cured and shaped product of a unidirectional prepreg in which carbon fibers are oriented in one direction;
when the orientation direction of carbon fibers in one of the two outermost CFRP layers, which are one-dimensionally reinforced CFRP layers located closest to the principal surface side in each of said two skin layers, is made to be a reference direction, the orientation direction of carbon fibers in the other outermost CFRP layer falls within an angle range from -20° to +20° with respect to the reference direction;
the tensile modulus of carbon fibers in both the two outermost CFRP layers is 200 GPa to 600 GPa;
both the two skin layers have a one-dimensionally reinforced CFRP layer containing carbon fibers oriented in an angle range from +75° to +90° with respect to the reference direction and having a tensile modulus 1.5 times to 3.0 times that of carbon fibers of the outermost CFRP layer contained in the skin layer, and/or a one-dimensionally reinforced CFRP layer containing carbon fibers oriented in an angle range from -75° to -90° with respect to the reference direction and having a tensile modulus 1.5 times to 3.0 times that of carbon fibers of the outermost CFRP layer contained in the skin layer;
said core layer has a one-dimensionally reinforced CFRP layer containing carbon fibers oriented in an angle range from -20° to +20° with respect to the reference direction and having a tensile modulus of 200 GPa to 400 GPa; and
said core layer also has a one-dimensionally reinforced CFRP layer containing carbon fibers oriented in an angle range from +75° to +90° with respect to the reference direction and having a tensile modulus of 200 GPa to 400 GPa and/or a one-dimensionally reinforced CFRP layer containing carbon fibers oriented in an angle range from -75° to -90° with respect to the reference direction and having a tensile modulus of 200 GPa to 400 GPa.

10. The dummy wafer according to claim 9, wherein at least one of said two skin layers further has a one-dimensionally reinforced CFRP layer containing carbon fibers oriented in an angle range from +30° to +60° with respect to the reference direction and having a tensile modulus 1.5 times to 3.0 times that of carbon fibers of the outermost CFRP layer contained in the skin layer, and/or a one-dimensionally reinforced CFRP layer containing carbon fibers oriented in an angle range from -30° to -60° with respect to the reference direction and having a tensile modulus 1.5 times to 3.0 times that of carbon fibers of the outermost CFRP layer contained in the skin layer.

11. The dummy wafer according to any one of claims 6 to 10 further comprising a carbon fiber cloth layer on each of the principal surfaces.

12. The dummy wafer according to any one of claims 1 to 11, wherein the matrix resin contained in said carbon fiber reinforced plastic contains an epoxy resin composition that contains diaminodiphenylsulfone as a curing agent.

13. The dummy wafer according to any one of claims 2 to 12, wherein
said wafer substrate has a processed surface, and
has a coating layer that coats said processed surface and consists of a resin that has resistance against polar solvent and cures at a temperature of 70°C or lower.
